# EUROPÄISCHE PATENTSCHRIFT

(11) **EP 2 163 911 B1**
(45) Veröffentlichungstag und Bekanntmachung des Hinweises auf die Patenterteilung: **26.01.2011**
(21) Anmeldenummer: 08016271.2
(22) Anmeldetag: 16.09.2008
(51) Int. Cl.: G01R 31/327

(54) **Verfahren zum Testen einer Schutzvorrichtung sowie entsprechend ausgestaltete Schutzvorrichtung und Testvorrichtung**
Method for testing a protective device and correspondingly equipped protective device and testing device
Procédé de test d'un dispositif de protection ainsi que dispositif de protection équipé correspondant et dispositif de test

(43) Veröffentlichungstag der Anmeldung: 17.03.2010
(73) Patentinhaber: Omicron electronics GmbH, 6833 Klaus (AT)
(72) Erfinder: Klapper, Ulrich, 6830 Rankweil (AT)
(74) Vertreter: Banzer, Hans-Jörg

(56) Entgegenhaltungen:
- EP-A- 1 939 642
- US-B1- 6 815 955
- OVCHAROV S ET AL: "Investigation on protective relays testing methods" ELECTRONICS TECHNOLOGY: CONCURRENT ENGINEERING IN ELECTRONIC PACKAGING , 2001. 24TH INTERNATIONAL SPRING SEMINAR ON 5-9 MAY 2001, PISCATAWAY, NJ, USA,IEEE, 5. Mai 2001 (2001-05-05), Seiten 243-247, XP010548202 ISBN: 978-0-7803-7111-8

## Beschreibung

Die vorliegende Erfindung betrifft ein Verfahren zum Testen einer Schutzvorrichtung für ein Energieübertragungsnetz, eine Schutzvorrichtung für ein Energieübertragungsnetz und eine Testvorrichtung, um die Schutzvorrichtung zu testen.

Um beispielsweise die Wahrscheinlichkeit von Blackouts bzw. einer Unterbrechung der Stromversorgung weiter zu senken oder diese Wahrscheinlichkeit auch bei dem ständig steigenden Energiebedarf zumindest konstant zu halten, müssen energietechnische Schutzvorrichtungen, wie z.B. Schutzrelais, immer zuverlässiger arbeiten bzw. sein. Aus diesem Grund ist es umso wichtiger, eine korrekte Funktionsweise dieser Schutzvorrichtungen möglichst genau und trotzdem mit einer möglichst kurzen Messzeit zu überprüfen.

Ein Verfahren zum Testen einer Schutzvorrichtung für ein Energieübertragungsnetz gemäß dem Oberbegriff des unabhängigen Anspruches 1 ist aus "Investigation on protective relays testing methods", OVCHAROV S. ET AL, ELECTRONICS TECHNOLOGY: CONCURRENT ENGINEERING IN ELECTRONIC PACKAGING, 2001, 24TH INTERNATIONAL SPRING SEMINAR ON 5-9 MAY 2001, IEEE, 5. Mai 2001, Seiten 243-247 bekannt. In dieser Druckschrift werden verschiedene statische und dynamische Testverfahren zum Testen von Schutzrelais für ein Energieübertragungsnetz vorgeschlagen, welche einen Test des jeweiligen Schutzrelais in Echtzeit ermöglichen.

Es ist die Aufgabe der vorliegenden Erfindung, einen Test einer Schutzvorrichtung für ein Energieübertragungsnetz gegenüber einem entsprechenden Test nach dem Stand der Technik zu beschleunigen.

Erfindungsgemäß wird diese Aufgabe durch ein Verfahren zum Testen einer Schutzvorrichtung für eine Energieübertragungsnetz nach Anspruch 1, eine Schutzvorrichtung für ein Energieübertragungsnetz nach Anspruch 8 und eine Testvorrichtung zum Testen einer Schutzvorrichtung nach Anspruch 11 gelöst. Die abhängigen Ansprüche definieren bevorzugte und vorteilhafte Ausführungsformen der vorliegenden Erfindung.

Im Rahmen der vorliegenden Erfindung wird ein Verfahren zum Testen einer Schutzvorrichtung für ein Energieübertragungsnetz bereitgestellt. Dabei wird ein Betriebsablauf der Schutzvorrichtung getestet, wobei der Betriebsablauf bei einem Einsatz der Schutzvorrichtung zum Schutz des Energieübertragungsnetzes eine bestimmte Betriebszeitspanne benötigt. Während des erfindungsgemäßen Testverfahrens wird der Betriebsablauf allerdings in einer kürzeren Zeitspanne als die Betriebszeitspanne des Betriebsablaufs getestet, indem beispielsweise eine Zeitmessvorrichtung der Schutzvorrichtung beschleunigt betrieben wird.

Indem Betriebsabläufe der Schutzvorrichtung während des Tests der Schutzvorrichtung in einer kürzeren Zeitspanne ablaufen bzw. getestet werden (also quasi schneller als in Echtzeit betrieben werden), kann der gesamte Test der Schutzvorrichtung vorteilhafterweise im Vergleich zum Stand der Technik in einer kürzeren Zeit durchgeführt werden. Mit anderen Worten ist es ein entscheidendes Merkmal der vorliegenden Erfindung, dass der Test der Schutzvorrichtung schneller als in Echtzeit durchgeführt wird.

Die Beschleunigung des Betriebsablaufs der Schutzvorrichtung während des Tests kann dabei insbesondere dadurch erreicht werden, dass die Zeitmessvorrichtung der Schutzvorrichtung, mit welcher die Schutzvorrichtung beispielsweise bestimmte vorgegebene Zeitdauern misst, schneller als während des normalen Betriebsablaufs betrieben wird. Die Zeitmessvorrichtung kann dabei beispielsweise derart schneller betrieben werden, indem eine Taktfrequenz der Zeitmessvorrichtung entsprechend erhöht wird.

Die Verkürzung der Testzeit ist gerade für moderne Schutzrelais interessant, da dabei eine wesentlich größere Anzahl von Testfällen durchzutesten ist. Wenn dabei die im Normalbetrieb der Schutzvorrichtung üblichen Zeiten für die jeweilige Vorfehler-, Fehler-, und Nachfehler-Situation in einem realen Energieübertragungsnetz berücksichtigt werden müssen, wie dies nach dem Stand der Technik heute der Fall ist, steigt die notwendige Testzeit stark an. Indem gerade diese Zeiten erfindungsgemäß wenn notwendig drastisch verkürzt werden, können auch die modernen Schutzrelais durch die vorliegende Erfindung in einem tolerierbaren Zeitrahmen getestet werden.

Bei einer bevorzugten erfindungsgemäßen Ausführungsform wird die Schutzvorrichtung zum Testen der Schutzvorrichtung selbst in einen speziellen Testbetrieb oder Testbetriebmodus umgeschaltet, in welchem beispielsweise die Zeitmessvorrichtung der Schutzvorrichtung beschleunigt betrieben wird.

Wenn die Schutzvorrichtung ein Tiefpassfilter aufweist, über welches die Schutzvorrichtung mit dem Energieübertragungsnetz verbunden ist, wird dieses Tiefpassfilter beim Testen der Schutzvorrichtung vorteilhafterweise umgangen.

Indem das Tiefpassfilter während des erfindungsgemäßen Testens der Schutzvorrichtung umgangen wird, können während des Testens der Schutzvorrichtung auch höherfrequente Datenströme zur Schutzvorrichtung übermittelt werden, um mit diesen Datenströmen die Schutzvorrichtung zu testen. Je schneller diese Datenströme, welche u.a. Testmuster zum Testen der Schutzvorrichtung umfassen, von der Schutzvorrichtung aufgenommen werden können, umso schneller können die entsprechenden Tests der Schutzvorrichtung durchgeführt werden, wodurch das erfindungsgemäße Verfahren zum Testen der Schutzvorrichtung beschleunigt wird.

Erfindungsgemäß kann die Schutzvorrichtung entweder eine analoge Schnittstelle oder eine digitale Schnittstelle (z.B. eine Schnittstelle gemäß IEC 61850-9-2) umfassen, über welche die Schutzvorrichtung entweder mit dem Energieübertragungsnetz verbunden ist oder getestet werden kann. Zumindest für den Fall, dass es sich um eine digitale Schnittstelle handelt, befindet sich zwischen dem Energieübertragungsnetz und der Schutzvorrichtung ein Wandler, welcher die digitale Schnittstelle mit Daten versorgt. Ein solcher Wandler ist in der Regel innerhalb der Schutzeinrichtung vorhanden, wenn die Schutzvorrichtung über eine analoge Schnittstelle verfügt.

Der Einsatz einer digitalen Schnittstelle ermöglicht, dass diese digitale Schnittstelle speziell gemäß der Anforderungen an ein möglichst rasches und komfortables Testen der Schutzvorrichtung ausgestaltet ist. Dabei ist es von Vorteil, wenn diese digitale Schnittstelle eine genormte digitale Schnittstelle ist, da ein Großteil der durchzuführenden Tests aus digitalen Testmustern besteht, wobei auch die entsprechenden Testantworten digitaler Art sein können. Natürlich kann die Schutzvorrichtung aber auch erfindungsgemäß getestet werden, wenn die Schutzvorrichtung eine analoge Schnittstelle aufweist.

Während eines Tests ist die Schutzvorrichtung normalerweise ausschließlich mit der Testvorrichtung gekoppelt. Dies kann auch über einen Wechselschalter erfolgen, mit dem die Schutzvorrichtung selektiv entweder mit dem Energieübertragungsnetz oder mit der Testvorrichtung gekoppelt werden kann.

Erfindungsgemäß ist es auch möglich, dass der jeweils nächste Testschritt (Abtastwert) dann bearbeitet wird, sobald der jeweils vorhergehende Testschritt fertig bearbeitet ist. Anders ausgedrückt wird bei einer digitalen Schnittstelle von der Schutzvorrichtung der jeweils nächste Abtastwert (von einer Testvorrichtung) angefordert, sobald notwendige Rechenoperationen in der Schutzvorrichtung (zur Bearbeitung des vorhergehenden Abtastwerts) abgeschlossen worden sind.

Nach dem Stand der Technik wartet eine Schutzvorrichtung bei manchen Testfällen eine vorbestimmte Zeitdauer (oder bei einer digitalen Schnittstelle eine bestimmte Anzahl von Abtastwerten), bis sie reagiert. Das Ergebnis eines Tests kann erst nach Ablauf dieser vorbestimmten Zeitdauer überprüft werden. Wenn es beispielsweise vorgeschrieben ist, dass die Schutzvorrichtung in einem bestimmten Fehlerfall nach einer vorbestimmten Zeitdauer einen Leistungsschalter zu betätigen hat, kann nach dem Stand der Technik erst nach dieser vorbestimmten Zeitdauer (oder nach der entsprechenden Anzahl von Abtastwerten) überprüft werden, ob ein Befehl zur Betätigung eines Leistungsschalters von der Schutzvorrichtung zur richtigen Zeit abgesetzt wurde oder nicht. Erfindungsgemäß wird dagegen die Schutzvorrichtung beschleunigt betrieben und in diesem Fall kann der entsprechende Testschritt früher bewertet werden, sobald erfasst wird, dass der Befehl zur Betätigung des Leistungsschalters (nach der richtigen Zeit) abgesetzt wurde. Erfindungsgemäß wird also gerade nicht die vorbestimmte Zeitdauer abgewartet, sondern der entsprechende Testschritt dann als erfolgreich gewertet, sobald das den Erfolg bestimmende Ergebnis (im Beispiel der Befehl zum Schalten des Leistungsschalters) vorliegt, wodurch der gesamte Test der Schutzvorrichtung vorteilhafterweise beschleunigt wird.

Es kann in diesem Zusammenhang eine Art Handshake-Verfahren bei der Testdurchführung eingesetzt werden, sodass die Daten (z.B. Abtastwerte) der Schutzvorrichtung so schnell zugeführt werden, wie diese in der Lage ist, sie zu verarbeiten. Damit wird eine gegenüber dem Stand der Technik beschleunigte Testdurchführung auch dann erzielt, wenn die Zeitmessvorrichtung nicht beschleunigt betrieben wird. Dabei wird unter einem Abtastwert ein digitalisierter Strom- oder Spannungswert von einem Energieübertragungsnetz zu einem bestimmten Zeitpunkt verstanden. Dieser Abtastwert kann auch von einem Testgerät simuliert werden.

Das Testen der Schutzvorrichtung kann dabei sowohl ein Anlegen entsprechender Testströme oder Testspannungen an die Schutzvorrichtung als auch ein Überprüfen von in der Schutzvorrichtung ablaufenden Algorithmen umfassen, wobei das Überprüfen der Algorithmen ein Überprüfen von Parametern oder Einstellwerten umfasst.

Dabei werden insbesondere Abtastwerte (als Testmuster) an die Schutzvorrichtung angelegt und die entsprechenden Testantworten bewertet. Da die Schutzvorrichtung in der Regel nicht zu jedem Zeitpunkt mit Rechenoperationen voll ausgelastet ist; können diese Tests, gerade wenn eine digitale Schnittstelle an der Schutzvorrichtung vorhanden ist, schneller als nach dem Stand der Technik durchgeführt werden, insbesondere bei Verwendung eines Handshake-Verfahrens. D.h. während nach dem Stand der Technik beispielsweise 80 Abtastwerte pro 20 ms, also 4000 Abtastwerte pro Sekunde, bei der Testdurchführung an die Schutzvorrichtung angelegt werden, kann diese Rate von Abtastwerten pro Sekunde bei der erfindungsgemäßen Testdurchführung abhängig von der maximal möglichen Taktgeschwindigkeit der Schutzvorrichtung deutlich gesteigert werden.

Im Rahmen der vorliegenden Erfindung wird auch eine Schutzvorrichtung für ein Energieübertragungsnetzes, welche eine Zeitmessvorrichtung umfasst, bereitgestellt. Die Schutzvorrichtung ist dabei derart ausgestaltet, dass die Schutzvorrichtung zum Schutz des Energieübertragungsnetzes einen Betriebsablauf durchführt. Dieser Betriebsablauf benötigt, wenn die Schutzvorrichtung den Betriebsablauf zum Schutz des Energieübertragungsnetzes durchführt, eine bestimmte Betriebszeitspanne. Die Schutzvorrichtung ist nun derart ausgestaltet, dass sie in einen Testmodus umschaltbar ist, in welchem die Schutzvorrichtung die Zeitmessvorrichtung derart beschleunigt betreibt, dass der Betriebsablauf in einer zum Vergleich der Betriebszeitspanne kürzeren Zeitspanne getestet werden kann.

Die Vorteile der erfindungsgemäßen Schutzvorrichtung entsprechen dabei im Wesentlichen den Vorteilen des erfindungsgemäßen Verfahrens, welche vorab im Detail ausgeführt sind, weshalb hier auf eine Wiederholung verzichtet wird.

Schließlich offenbart die vorliegende Erfindung auch eine Testvorrichtung, um damit die erfindungsgemäße Schutzvorrichtung zu testen.

Bei einer bevorzugten erfindungsgemäßen Ausführungsform ist die Testvorrichtung derart ausgestaltet, dass sie zwischen einem ersten Testmodus und einem zweiten Testmodus umgeschaltet werden kann. In dem ersten Testmodus testet die Testvorrichtung die Schutzvorrichtung in Echtzeit, d.h. ein Betriebsablauf der Schutzvorrichtung wird in derselben Zeit (Betriebszeitspanne) getestet, welche die Schutzvorrichtung zur Durchführung des Betriebsablaufs beim Einsatz der Schutzvorrichtung zum Schutz des Energieübertragungsnetzes benötigt. In dem zweiten Testmodus testet die Testvorrichtung die Schutzvorrichtung dagegen schneller als in Echtzeit, d.h. der Betriebsablauf der Schutzvorrichtung wird in einer Zeitspanne getestet, welche kürzer als eine Betriebszeitspanne ist, die die Schutzvorrichtung zur Durchführung des Betriebsablaufs zum Schutz des Energieübertragungsnetzes benötigt.

Die vorliegende Erfindung ist insbesondere geeignet, um ein Schutzrelais, mit welchem ein Energieübertragungsnetz vor einem Fehler geschützt wird, zu testen. Selbstverständlich ist die vorliegende Erfindung nicht auf diesen bevorzugten Anwendungsbereich beschränkt, sondern kann überall dort vorteilhafterweise eingesetzt werden, wo ein Betriebsablauf beim Testen in einer kürzeren Zeit als der normalen Betriebszeitspanne des Betriebsablaufs getestet werden kann.

Im Folgenden wird die vorliegende Erfindung anhand von Ausführungsbeispielen mit Bezug auf die Figuren im Detail erläutert.
Fig. 1 stellt eine erfindungsgemäße Testvorrichtung dar, welche über ein Energieübertragungsnetz mit einem erfindungsgemäßen Schutzrelais über eine analoge Schnittstelle verbunden ist.
Fig. 2 stellt eine erfindungsgemäße Testvorrichtung dar, welche über ein Energieübertragungsnetz mit einem erfindungsgemäßen Schutzrelais über eine digitale Schnittstelle verbunden ist.

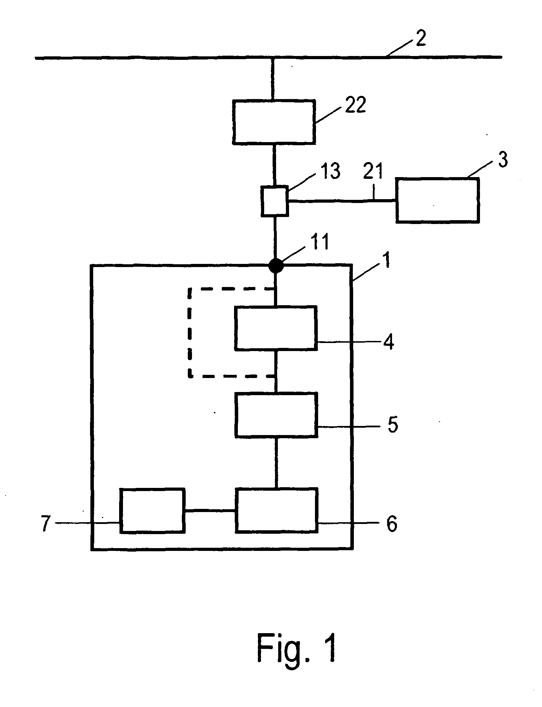

In Fig. 1 ist schematisch ein erfindungsgemäßes Schutzrelais 1 dargestellt, welches über eine analoge Schnittstelle 11 mittels eines Wandlers 22 mit einem Energieübertragungsnetz 2 verbunden ist. Das Schutzrelais 1 überprüft die Ströme und Spannungen auf dem Energieübertragungsnetz 2. Sobald das Schutzrelais 1 dabei einen Fehler erfasst, betätigt das Schutzrelais 1 einen Leistungsschalter (nicht dargestellt), um einen Teil des Energieübertragungsnetzes 2, in welchem ein Fehlverhalten vorliegt, von dem restlichen Teil des Energieübertragungsnetzes 2 abzutrennen.

Zur Überprüfung auf einen Fehler im Energieübertragungsnetz 2 werden dazu die zu überprüfenden Daten (Ströme und Spannungen) mit einem Tiefpassfilter 4 gefiltert und dann mit Hilfe eines A/D-Wandlers 5 digitalisiert. Die derart digitalisierten Daten werden dann mittels Prüfalgorithmen analysiert, wozu das Schutzrelais 1 eine CPU 6 und einen Zeitmesser 7 umfasst. Mit Hilfe des Zeitmessers 7, welcher ebenfalls durch bestimmte in der CPU 6 ablaufende Programme realisiert sein könnte, werden bestimmte Zeitdauern gemessen oder bestimmt, um beispielsweise mit dem Schutzrelais 1 zu überprüfen, ob ein bestimmtes Fehlverhalten innerhalb des Energieübertragungsnetzes 2 nach einer vorbestimmten Zeitspanne immer noch vorliegt, um dann gegebenenfalls entsprechend reagieren zu können.

Zum Testen des Schutzrelais 1 ist das Schutzrelais 1 über einen Wechselschalter 13 und eine Prüfverbindung 21 mit einem erfindungsgemäßen Testgerät 3 verbunden. Über diesen Wechselschalter 13 ist das Schutzrelais 1 entweder mit dem Wandler 22 und damit mit dem Energieübertragungsnetz 2 oder über die Prüfverbindung 21 mit dem Testgerät 3 verbunden. Es sei darauf hingewiesen, dass ein solcher Wechselschalter 13 in der Praxis nicht vorhanden sein muss.

Während eines Testbetriebs schaltet das Testgerät 3 das Schutzrelais 1 in einen speziellen Testmodus, in welchem das Schutzrelais 1 das Tiefpassfiltern 4 umgeht, so dass auch höherfrequente Datenströme von dem Testgerät 3 von der CPU 6 des Schutzrelais 1 während des Tests verarbeitet werden können. Darüber hinaus weist das Testgerät 3 den Zeitmesser 7 an, im Vergleich zu einem Normalbetrieb, in welchem das Schutzrelais 1 nicht getestet wird, sondern ausschließlich das Energieübertragungsnetz 2 überwacht wird, schneller zu laufen, so dass von dem Zeitmesser 7 gemessene oder vorgegebene Zeitspannen im Vergleich zu dem Normalbetrieb bzw. im Vergleich zur Echtzeit verkürzt werden.

Es ist auch möglich, dass das Testgerät 3 das Schutzrelais 1 (und insbesondere die CPU 6) anweist, insgesamt schneller als im Normalbetrieb zu arbeiten, um die von dem Testgerät 3 zu überprüfenden Betriebsabläufe schneller durchzutesten, wodurch der Test des Schutzrelais 1 weniger Zeit benötigt.

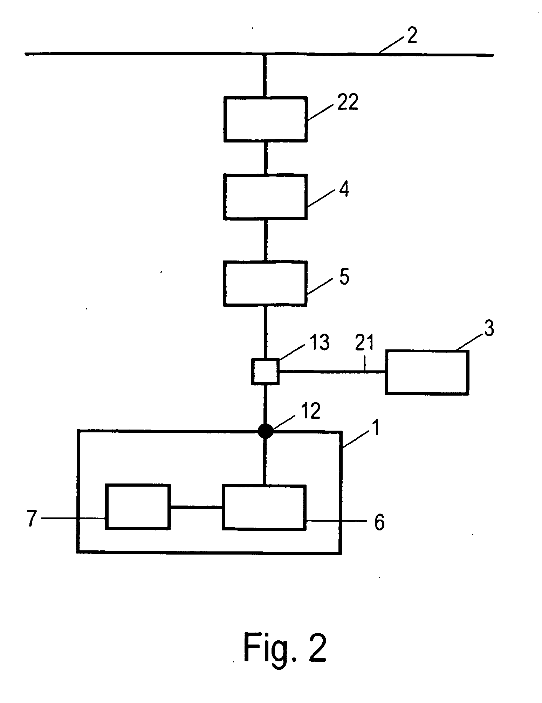

In Fig. 2 ist eine weitere erfindungsgemäße Ausführungsform eines Schutzrelais 1 und eines Testgeräts 3 schematisch dargestellt. Die in Fig. 2 dargestellte Ausführungsform entspricht dabei grundsätzlich der in Fig. 1 dargestellten Ausführungsform, weshalb dieselben Bezugszeichen verwendet werden und im Folgenden nur auf die Unterschiede zwischen der in Fig. 1 und der in Fig. 2 dargestellten Ausführungsformen eingegangen wird. Im Vergleich zu der in Fig. 1 dargestellten Ausführungsform weist das Schutzrelais 1 bei der Ausführungsform in Fig. 2 eine digitale Schnittstelle 12 auf. Aus diesem Grund weist das Schutzrelais 1 bei der in Fig. 2 dargestellten Ausführungsform auch weder ein Tiefpassfilter 4 noch einen A/D-Wandler 5 auf, welche beide auf der Seite des Wandlers 22 vorhanden sind. Es ist dabei möglich, dass das Tiefpassfilter 4 und der A/D-Wandler 5 in dem Wandler 22 integriert sind.

Die digitale Schnittstelle 12 ist dabei in aller Regel eine normierte Schnittstelle, beispielsweise eine Schnittstelle gemäß IEC 61850-9-2. Dadurch können bestimmte Tests des Schutzrelais 1, bei welchen digitale Testmuster von dem Testgerät 3 an das Schutzrelais 1 angelegt und entsprechende digitale Testantworten von dem Schutzrelais 1 an das Testgerät 3 zurück übertragen werden, wesentlich schneller ausgeführt werden, als es bei einer analogen Schnittstelle der Fall ist, wobei die Testmuster und die Testantworten von dem Testgerät 3 bzw. Schutzrelais 1 in eine analoge Form gewandelt und dann übertragen werden.

Dabei ist sowohl bei den in Fig. 1 als auch bei den in Fig. 2 dargestellten Ausführungsformen des Schutzrelais 1 und des Testgeräts 3 sowohl das Schutzrelais 1 als auch das Testgerät 3 derart ausgestaltet, dass es jeweils zwei Betriebsmodi unterstützt. In dem jeweils ersten Betriebsmodus wird das Schutzrelais 1 in Echtzeit getestet, was bedeutet das der Test eines Betriebsablaufs des Schutzrelais 1 genauso lang dauert, wie dieser Betriebsablauf im Normalbetrieb des Schutzrelais 1 dauert. Mit anderen Worten arbeitet auch das Testgerät 3 in diesem ersten Betriebsmodus derart, dass es die Tests in der dem Normalbetrieb des Schutzrelais 1 entsprechenden Zeit an das Schutzrelais 1 anlegt. In dem jeweils zweiten Betriebsmodus wird das Schutzrelais 1 schneller getestet, was bedeutet, dass der Test eines Betriebsablaufs des Schutzrelais 1 weniger Zeit benötigt, als der Betriebsablauf des Schutzrelais 1 im Normalbetrieb des Schutzrelais 1 benötigt. Mit anderen Worten arbeitet zum einen das Schutzrelais 1 in dem zweiten Betriebsmodus schneller und zum anderen arbeitet auch das Testgerät 3 in diesem zweiten Betriebsmodus schneller, indem es die Tests schneller an das Schutzrelais 1 anlegt und auswertet.

## Patentansprüche

1. Verfahren zum Testen einer Schutzvorrichtung für ein Energieübertragungsnetz (2),
wobei ein Betriebsablauf der Schutzvorrichtung (1) getestet wird, dessen Ablauf bei einem Einsatz der Schutzvorrichtung (1) zum Schutz des Energieübertragungsnetzes (2) eine bestimmte Betriebszeitspanne benötigt,
**dadurch gekennzeichnet,**
**dass** zum Testen der Schutzvorrichtung (1) eine Zeitmessvorrichtung (7) der Schutzvorrichtung (1) derart beschleunigt betrieben wird, dass der Betriebsablauf in einer kürzeren Zeitspanne als die Betriebszeitspanne des Betriebsablaufs getestet wird.

2. Verfahren nach Anspruch 1,
**dadurch gekennzeichnet,**
**dass** die Schutzvorrichtung ein Schutzrelais (1) ist.

3. Verfahren nach einem der vorhergehenden Ansprüche,
**dadurch gekennzeichnet,**
**dass** die Schutzvorrichtung (1) zum Testen in einen speziellen Testbetrieb umgeschaltet wird.

4. Verfahren nach einem der vorhergehenden Ansprüche,
**dadurch gekennzeichnet,**
**dass** ein Tiefpassfilter (4) der Schutzvorrichtung (1), mittels welchem die Schutzvorrichtung (1) mit dem Energieübertragungsnetz (2) verbunden ist, beim Testen der Schutzvorrichtung (1) umgangen wird.

5. Verfahren nach einem der vorhergehenden Ansprüche,
**dadurch gekennzeichnet,**
**dass** die Schutzvorrichtung (1) eine Schnittstelle aufweist, über welche die Schutzvorrichtung entweder zum Schutz des Energieübertragungsnetzes (2) mit dem Energieübertragungsnetz (2) verbunden ist, und
**dass** die Schnittstelle analog (11) oder digital (12) ausgebildet ist.

6. Verfahren nach einem der vorhergehenden Ansprüche,
**dadurch gekennzeichnet,**
**dass** die Schutzvorrichtung (1) mit mindestens einem Abtastwert beliefert wird, sobald erfasst wird, dass die Schutzvorrichtung (1) in der Lage ist, mindestens einen weiteren Abtastwert zu verarbeiten.

7. Verfahren nach einem der vorhergehenden Ansprüche,
**dadurch gekennzeichnet,**
**dass** das Testen der Schutzvorrichtung (1) sowohl ein Anlegen entsprechender Testströme oder Testspannungen an die Schutzvorrichtung (1) als auch ein Abprüfen von in der Schutzvorrichtung (1) ablaufenden Algorithmen umfasst, und dass das Abprüfen der Algorithmen ein Abprüfen von Parametern umfasst.

8. Schutzvorrichtung für ein Energieübertragungsnetz (2),
wobei die Schutzvorrichtung (1) eine Zeitmessvorrichtung (7) umfasst,
wobei die Schutzvorrichtung (1) derart ausgestaltet ist, dass die Schutzvorrichtung (1) einen Betriebsablauf durchführt, dessen Ablauf bei einem Einsatz der Schutzvorrichtung (1) zum Schutz des Energieübertragungsnetzes (2) eine bestimme Betriebszeitspanne benötigt,
**dadurch gekennzeichnet,**
**dass** die Schutzvorrichtung (1) in einen Testmodus umschaltbar ist, in welchem die Schutzvorrichtung (1) die Zeitmessvorrichtung (7) derart beschleunigt betreibt, dass der Betriebsablauf in einer kürzeren Zeitspanne als die Betriebszeitspanne des Betriebsablaufs testbar ist.

9. Schutzvorrichtung nach Anspruch 8,
**dadurch gekennzeichnet,**
**dass** die Schutzvorrichtung (1) eine Schnittstelle umfasst, über welche die Schutzvorrichtung (1) entweder zum Schutz des Energieübertragungsnetzes (2) mit dem Energieübertragungsnetz (2) verbindbar ist, und
**dass** die Schnittstelle analog (11) oder digital (12) ausgebildet ist.

10. Schutzvorrichtung nach Anspruch 8 oder 9,
**dadurch gekennzeichnet,**
**dass** die Schutzvorrichtung (1) zur Durchführung des Verfahrens nach einem der Ansprüche 1-8 ausgestaltet ist.

11. Testvorrichtung zum Testen einer Schutzvorrichtung (1) für ein Energieübertragungsnetz (2),
wobei die Schutzvorrichtung (1) derart ausgestaltet ist, dass die Schutzvorrichtung (1) einen Betriebsablauf durchführt, dessen Ablauf bei einem Einsatz der Schutzvorrichtung (1) zum Schutz des Energieübertragungsnetzes (2) eine bestimmte Betriebszeitspanne benötigt,
**dadurch gekennzeichnet,**
**dass** die Testvorrichtung (3) derart ausgestaltet ist, dass die Testvorrichtung (3) zwischen einem ersten Testmodus, in welchem die Testvorrichtung (3) die Schutzvorrichtung (1) in Echtzeit testet, und einem zweiten Testmodus, in welchem die Testvorrichtung (3) die Schutzvorrichtung (1) schneller als in Echtzeit testet, umschaltbar ist, so dass die Testvorrichtung (3) in dem zweiten Testmodus den Betriebsablauf der Schutzvorrichtung (1) in einer kürzeren Zeitspanne als die Betriebszeitspanne des Betriebsablaufs testet.

12. Testvorrichtung nach Anspruch 11,
**dadurch gekennzeichnet,**
**dass** die Testvorrichtung (3) zur Durchführung des Verfahrens nach einem der Ansprüche 1-7 ausgestaltet ist.

## Claims

1. Method for testing a protective device for a power grid (2),
wherein an operating procedure of the protective device (1) is tested, an operation of which requiring a predetermined operating period during a use of the protective device (1) for protecting the power grid (2),
**characterized in that**
a timing device (7) of the protective device (1) is operated in an accelerated manner for testing the protective device (1) such that the operating procedure is tested in a shorter time period than the operating period of the operating procedure.

2. Method according to claim 1,
**characterized in that**
the protective device is a protective relay (1).

3. Method according to any one of the preceding claims,
**characterized in that**
the protective device (1) is switched into a specific test mode for testing.

4. Method according to any one of the preceding claims,
**characterized in that**
a low pass filter (4) of the protective device (1), by which the protective device (1) is coupled to the power grid (2), is bypassed during testing the protective device (1).

5. Method according to any one of the preceding claims,
**characterized in that**
the protective device (1) comprises an interface via which the protective device is either coupled to the power grid (2) for protecting the power grid (2), and
the interface is analog (11) or digital (12).

6. Method according to any one of the preceding claims,
**characterized in that**
at least one sample is supplied to the protective device (1) as soon as it is detected that the protective device (1) is able to process at least another sample.

7. Method according to any one of the preceding claims,
**characterized in that**
the testing of the protective device (1) comprises applying of corresponding test currents or test voltages to the protective device (1) as well as verifying of algorithms processed in the protective device (1), and
the verifying of the algorithms comprises verifying of parameters.

8. Protective device for a power grid (2),
wherein the protective device (1) comprises a timing device (7), wherein the protective device (1) is configured such that the protective device (1) executes an operating procedure, an operation of which requiring a predetermined operating period during a use of the protective device (1) for protecting the power grid (2),
**characterized in that**
the protecting device (1) is switchable into a test mode in which the protective device (1) operates the timing device (7) in an accelerated manner such that the operating procedure is testable in a shorter time period than the operating period of the operating procedure.

9. Protective device according to claim 8,
**characterized in that**
the protective device (1) comprises an interface via which the protective device (1) is either coupleable to the power grid (2) for protecting the power grid (2), and
the interface is analog (11) or digital (12).

10. Protective device according to claim 8 or 9,
**characterized in that**
the protective device (1) is adapted to perform the method according to any one of claims 1-8.

11. Testing device for testing a protective device (1) for a power grid (2),
wherein the protective device (1) is configured such that the protective device (1) performs an operating procedure, an operation of which requiring a predetermined operating period during a use of the protective device (1) for protecting the power grid (2),
**characterized in that**
the testing device (3) is configured such that the testing device (3) is switchable between a first test mode in which the testing device (3) tests the protective device (1) in real time, and a second testing mode in which the testing device (3) tests the protective device (1) faster than in real time, such that the testing device (3) tests the operating procedure of the protective device (1) in a shorter time period than the operating period of the operating procedure.

12. Testing device according to claim 11,
**characterized in that**
the testing device (3) is adapted to perform the method according to any one of claims 1-7.

## Revendications

1. Procédé de test d'un dispositif de protection pour un réseau de transmission d'énergie (2),
où une séquence de fonctionnement du dispositif de protection (1) est testée, dont le déroulement nécessite un intervalle de temps de service défini pour une utilisation du dispositif de protection (1) pour la protection du réseau de transmission d'énergie (2),
**caractérisé en ce qu'**un dispositif de mesure temporelle (7) du dispositif de protection (1) est mis en service de manière accélérée pour le test du dispositif de protection (1), de manière à tester la séquence de fonctionnement dans un intervalle de temps inférieur à l'intervalle de temps de service de la séquence de fonctionnement.

2. Procédé selon la revendication 1,
**caractérisé en ce que** le dispositif de protection est un relais de protection (1).

3. Procédé selon l'une des revendications précédentes,
**Caractérisé en ce que** le dispositif de protection (1) est commuté pour un test dans un mode de test spécifique.

4. Procédé selon l'une des revendications précédentes,
**Caractérisé en ce qu**'un filtre passe-bas (4) du dispositif de protection (1), au moyen duquel le dispositif de protection (1) est relié au réseau de transmission d'énergie (2), est contourné lors du test dispositif de protection (1).

5. Procédé selon l'une des revendications précédentes,
**caractérisé en ce que** le dispositif de protection (1) comporte une interface par laquelle le dispositif de protection est relié au réseau de transmission d'énergie (2) pour la protection du réseau de transmission d'énergie (2), et **en ce que** l'interface est réalisée analogiquement (11) ou numériquement (12).

6. Procédé selon l'une des revendications précédentes,
**Caractérisé en ce que** le dispositif de protection (1) est fourni avec au moins une valeur de balayage, dès qu'il est déterminé que le dispositif de protection (1) est en mesure de traiter au moins une autre valeur de balayage.

7. Procédé selon l'une des revendications précédentes,
**caractérisé en ce que** le test du dispositif de protection (1) comprend l'application de courants de test ou de tensions de test correspondants sur le dispositif de protection (1), ainsi qu'un contrôle des algorithmes exécutés dans le dispositif de protection (1), et **en ce que** le contrôle des algorithmes comprend un contrôle de paramètres.

8. Dispositif de protection pour un réseau de transmission d'énergie (2),
où le dispositif de protection (1) comprend un dispositif de mesure temporelle (7),
le dispositif de protection (1) étant réalisé de telle manière que le dispositif de protection (1) exécute une séquence de fonctionnement dont le déroulement nécessite un intervalle de temps de service défini pour une utilisation du dispositif de protection (1) pour la protection du réseau de transmission d'énergie (2),
**caractérisé en ce que** le dispositif de protection (1) est commutable en un mode de test où le dispositif de protection (1) met en service le dispositif de mesure temporelle (7) de manière accélérée, de telle manière que la séquence de fonctionnement peut être testée dans un intervalle de temps inférieur à l'intervalle de temps de service de la séquence de fonctionnement.

9. Dispositif de protection selon la revendication 8,
**caractérisé en ce que** le dispositif de protection (1) comprend une interface par laquelle le dispositif de protection peut être relié au réseau de transmission d'énergie (2) pour la protection du réseau de transmission d'énergie (2), et **en ce que** l'interface est réalisée analogiquement (11) ou numériquement (12).

10. Dispositif de protection selon la revendication 8 ou la revendication 9,
**caractérisé en ce que** le dispositif de protection (1) est réalisé selon l'une des revendications 1 à 8 pour l'exécution du procédé.

11. Dispositif de test, destiné à tester un dispositif de protection (1) pour un réseau de transmission d'énergie (2),
où le dispositif de protection (1) est réalisé de telle manière que le dispositif de protection (1) exécute une séquence de fonctionnement dont le déroulement nécessite un intervalle de temps de service défini pour une utilisation du dispositif de protection (1) pour la protection du réseau de transmission d'énergie (2),
**caractérisé en ce que** le dispositif de test (3) est réalisé de telle manière que le dispositif de test (3) est commutable entre un premier mode de test, où le dispositif de test (3) teste le dispositif de protection (1) en temps réel, et un deuxième mode de test, où le dispositif de test (3) teste le dispositif de protection (1) plus rapidement qu'en temps réel, de telle manière que le dispositif de test (3) teste en deuxième mode de test la séquence de fonctionnement du dispositif de protection (1) dans un intervalle de temps inférieur à l'intervalle de temps de service de la séquence de fonctionnement.

12. Dispositif de test selon la revendication 11,
**caractérisé en ce que** le dispositif de test (3) est réalisé selon l'une des revendications 1 à 7 pour l'exécution du procédé.
